# EUROPEAN PATENT SPECIFICATION

(11) **EP 2 593 588 B1**
(45) Date of publication and mention of the grant of the patent: **22.06.2016**
(21) Application number: 11743801.0
(22) Date of filing: 13.07.2011
(51) Int. Cl.: C25D 7/12, C25D 17/00, C25D 17/10, H01L 21/683

(54) **A CONTACT SHEET FOR ARRANGEMENT BETWEEN A CHUCK AND A MASTER ELECTRODE IN AN ECPR PROCESS**
KONTAKTFOLIE ZUR EINFÜGUNG ZWISCHEN EINEM FUTTER UND EINER MASTER-ELEKTRODE IN EINEM ECPR-VERFAHREN
FEUILLE DE CONTACT POUR AGENCEMENT ENTRE UN SUPPORT INDIVIDUEL DE TRANCHE ET UNE ÉLECTRODE PRINCIPALE DANS UN PROCÉDÉ ECPR

(30) Priority: 16.07.2010 US 364989 P; 15.07.2010 SE 1050797
(43) Date of publication of application: 22.05.2013
(73) Proprietor: Centre de Recherche Public - Gabriel Lippmann, 4422 Belvaux (LU)
(72) Inventor: MÖLLER, Patrik, 112 32 Stockholm (SE); FREDENBERG, Mikael, 112 45 Stockholm (SE); UTTERBÄCK, Tomas, 762 61 Rimbo (SE); SANTOS, Antonio, 164 45 Kista (SE); CHAUVET, Jean-Michel, 125 43 Älvsjö (SE); LINDGREN, Lennart, 125 33 Älvsjö (SE); ROSÉN, Daniel, 112 44 Stockholm (SE); SVENSSON, Stefan, 182 31 Danderyd (SE)
(74) Representative: Lecomte & Partners
(86) International application number: PCT/EP2011/061991
(87) International publication number: WO 2012/007521

(56) References cited:
- WO-A1-2010/054677
- US-A1- 2002 127 956

## Description

### Field of the Invention

This invention pertains in general to the field of electrochemical pattern replication. More particularly the invention relates to methods for bringing a master electrode in contact with a substrate, methods for separating a master electrode and a substrate, several devices and configurations for improving ECPR.

### Background of the Invention

Electroplating/electroetching is used for microelectronics in a wide range of applications, such as interconnects, components, waveguides, inductors, contact pads etc.

In the field of microelectronics electroplating/electroetching is suitable for applications involving production of micro and nano structures in single or multiple layers, fabrication of PWB (printed wiring boards), PCB (printed circuit boards), MEMS (micro electro mechanical systems), IC (integrated circuit) interconnects, above IC interconnects, sensors, flat panel displays, magnetic and optical storage devices, solar cells and other electronic devices. It can also be used for different types of structures in conductive polymers, structures in semiconductors, structures in metals, and others. Even 3D-structures in silicon, such as by formation of porous silicon, are possible.

Chemical vapour deposition and physical vapour deposition are processes that may also be used for metallization, but electroplating/electroetching is often preferred since it is generally cheaper than other metallization processes and it can take place at ambient temperatures and at ambient pressures.

Electroplating/electroetching of a work piece takes place in a reactor containing an electrolyte. An anode, carrying the metal to be plated, is connected to a positive voltage. In some cases, the anode is inert and the metal to be plated comes from the ions in the electrolyte. The conductivity of the work piece, such as a semiconductor substrate, is generally too low to allow the structures to be plated to be connected through the substrate to backside contacts. Therefore, the structures to be plated first have to be provided with a conductive layer, such as a seed layer. Leads connect the pattern to finger contacts on the front side. The finger contacts are in turn connected to a negative voltage. The electroplating step is an electrolytic process where the metal is transferred from the anode, or from the ions in the electrolyte, to the conductive pattern (cathode) by the electrolyte and the applied electric field between the anode and the conductive layer on the work piece, which forms the cathode.

The ever-increasing demand for smaller, faster and less expensive microelectronic and micro-electromechanical systems requires corresponding development of efficient and suitable manufacturing techniques, which has resulted in the development of electrochemical pattern replication (ECPR).

In ECPR plating/etching cells or cavities are formed between a master electrode and the substrate, said cavities being defined by a conductive surface on the master electrode, an insulating material, defining the pattern to be plated/etched, and the conductive surface of the substrate. During plating, a predeposited anode material has been arranged, normally through electrochemical plating, in the cavities. The master electrode and the substrate are put in close contact with each other in the presence of an electrolyte, suitable for the intended purpose, such that the electrolyte is "trapped" in the ECPR plating/etching cavities. WO 02/103085, to the present inventors, describes a system of this kind.

WO2010/054677 describes a method of making an electrical connection to a master electrode held in a chuck in an ECPR process in which the electrode is held spaced from the surface of the chuck, and resilient conductors connect the electrode terminals to the chuck across the gap. Electrolyte is prevented from leaking behind the electrode by seals.

### Summary of the Invention

The present invention preferably seeks to mitigate, alleviate or eliminate one or more deficiencies in the art and disadvantages singly or in any combination, by providing a contact sheet for making electrical contact to a master electrode and fixating said master electrode in an ECPR process, said contact sheet having a first proximal side and a second distal side, said contact sheet comprising an insulating carrier sheet; distal electrically conductive contact portions arranged distally of the insulating carrier sheet; proximal electrically conductive contact portions arranged proximally of the insulating carrier sheet; said distal and proximal electrically conductive contact portions being connected by an electrically conductive material through the insulating carrier sheet.

### Brief Description of the Drawings

These and other aspects, features and advantages of which the invention is capable of will be apparent and elucidated from the following description of embodiments of the present invention, reference being made to the accompanying drawings, in which
Fig. 1 is a schematic cross section of a conductive foil according to one embodiment of the present invention
Fig. 2 is front view of a backside of a conductive foil according to one embodiment of the present invention;
Fig. 3 is front view of a frontside of a conductive foil according to one embodiment of the present invention;
Fig. 4 is a front view of a close up of a frontside of a conductive foil according to one embodiment of the present invention;
Fig. 5 is a sheet of an exploded view, disclosing the conductive zones and terminals of a conductive foil according to one embodiment of the present invention; and
Fig. 6 is a sheet of an exploded view, disclosing the electrical vias between conductive zones and conductive ridges according to one embodiment of the present invention.

### Description of embodiments

The following description focuses on embodiments applicable to an ECPR process, and devices and methods suitable therefore. However, it will be appreciated that the invention is not limited to this application but may be applied to many other replicating or etching processes within the field of micro electronics and/or mechanics, including for example wafer bonding, various lithographic processes, dry or wet etching processes, etc.

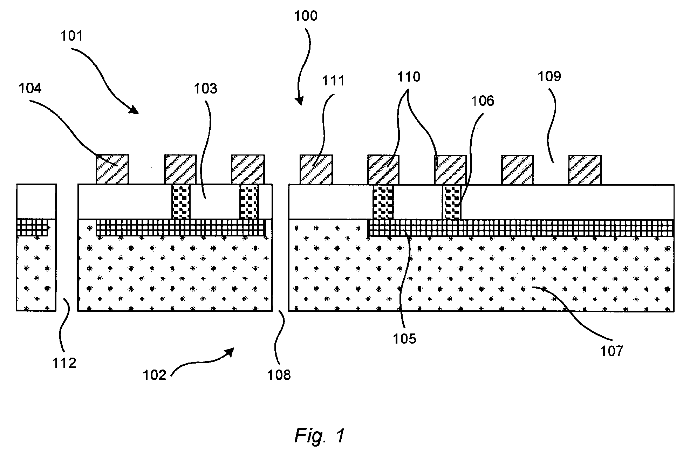

In Fig. 1 a schematic cress sectional view of an embodiment of a conductive foil 100, to be applied between a chuck and a master electrode, is provided. A purpose of the conductive foil 100 is to make electrical contact to the backside of the master electrode, having an electrode surface on the back of the master electrode. A second purpose is to hold the master electrode in place on the chuck, i.e. to hold it down in a proximodistal direction, and stabilize the master electrode on the chuck in the lateral/horizontal direction. A third purpose of the conductive foil 100 is to create a sealing between the edge of the master electrode and the underlying chuck so that we do not get electrolyte leaking in between the master electrode and the chuck. A fourth purpose of the conductive foil 100 is to enable uniform shape control of the master electrode. I fifth purpose is to electrically connect the master electrode at several positions, such as rings and/or segments of the backside of the master electrode.

The conductive foil has a first side 101, a distal side, facing the master electrode in use, and a second side 102, a proximal side, facing the chuck in use. The conductive foil 100 comprises an insulating carrier 103. The insulating carrier 103 may be of a suitable plastic material that is flexible on the global scale but not in the local scale of the present context of ECPR. A suitable plastic material is for example a liquid crystal polymer, such as LCP or PTFE or another fluorinated polymer material. In one embodiment foams of these polymers are used. Foams of these polymers provide the effect of not having to transfer mass in other directions than the compressing direction, due to the open cell structure of foams. A suitable thickness is 30 to 70 micrometers, such as 40 to 60 micrometers.

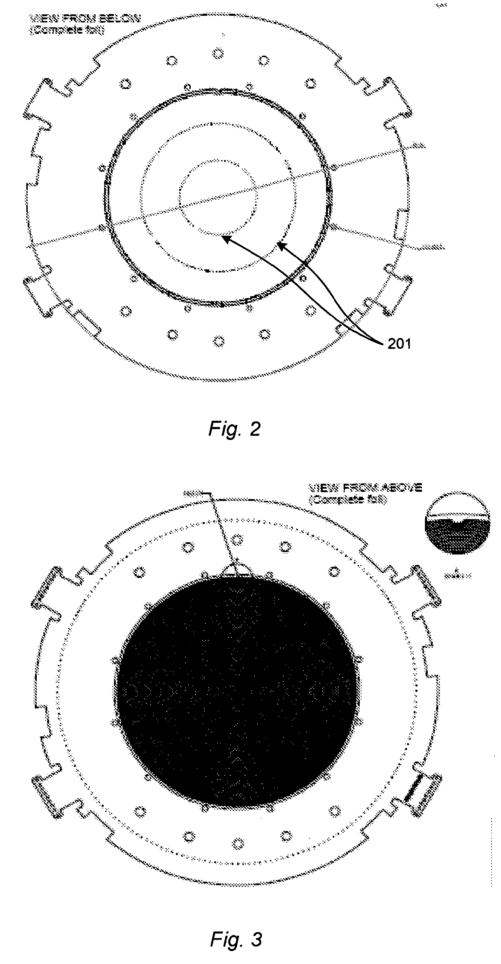

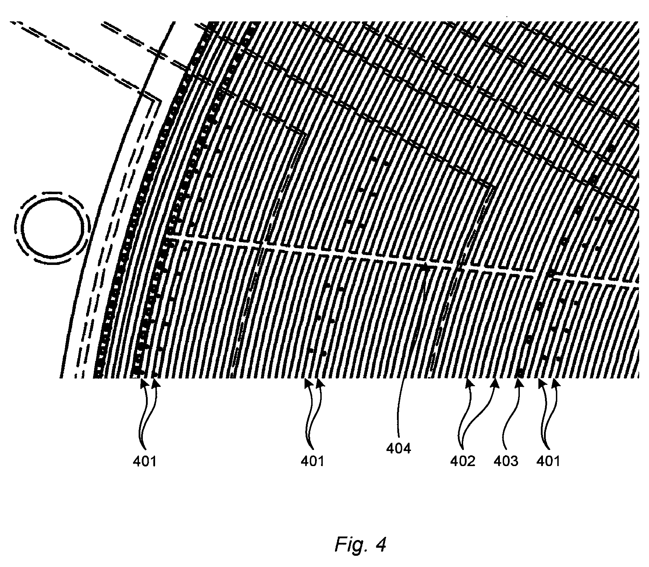

Distally of the insulating carrier sheet 103 a contact layer 104 is arranged onto said insulating carrier sheet 103. The contact layer 104 is suitably of copper, gold, silver, nickel, platinum, titanium, palladium, or an alloy thereof or by multiple layers thereof, and a suitable thickness may be selected in the interval of 1 to 100 micrometers, such as 20 to 30 micrometers. The contact layer 104 may be formed as rings or meander-shaped configurations, pads, and concentric formations of these. The pattern of the contact layer 104 may be obtained by etching away copper, such as by lithography, after arranging a copper sheet onto the carrier sheet 103. This is more specifically disclosed in Figs. 3 and 4. The pattern of the contact layer can also be obtained by lithography and plating, such as electroplating, immersion plating or electroless plating. Since the contact layer comprise several layers of different material, it may be formed by multiple lithography, etching and/or plating steps.

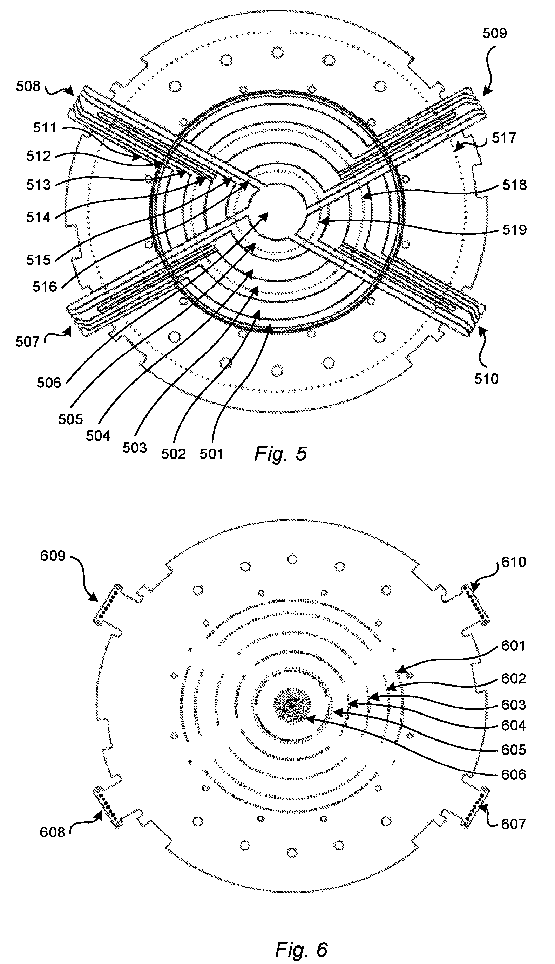

On the proximal side of the insulating carrier sheet 103 a routing layer 105 is arranged onto said insulating carrier sheet 103. The routing layer 105 is suitably of copper, gold, silver, nickel, platinum, titanium, palladium, or an alloy thereof or by multiple layers thereof, and a suitable thickness may be selected in the interval of 1 to 100 micrometers, such as 20 to 30 micrometers. The routing layer 105 may be formed as segments with leads to terminals, such that different segments, corresponding to different concentric formations of the contact layer 104 on the distal side of the insulating carrier sheet 103, may be provided with separate voltage/current, such that different parts of the distal side of the conductive foil 100 may be provided with separate voltage/current, such that the supply of current may assure an even distribution and plating on the substrate. The leads (shown in Fig. 6) may be arranged to extend radially outwards/laterally, to be connected to en external power supply circumferentially of the master electrode and the substrate. The pattern of the routing layer 105 may be obtained by etching away copper, such as by lithography, after arranging a copper sheet onto the carrier sheet 103. This is more specifically disclosed in Fig. 5. The pattern of the contact layer can also be obtained by lithography and plating, such as electroplating, immersion plating or electroless plating. Since the contact layern comprise several layers of different material, it may be formed by multiple lithography, etching and/or plating steps.

The contact layer 104 and the routing layer 105 are connected to each other through the insulating carrier sheet 103 by conductive connections 106, arranged in vias of the insulating carrier sheet 103. The conductive connections 106 are made of a suitable conductive material, such as metal, such as copper.

On the proximal side of the insulating carrier sheet 103 and the routing layer 105, a cushion layer 107 may be arranged. It is however also possible to arrange a cushion layer 107 directly on the chuck. The cushion layer 107 is soft and flexible in the proximodistal direction, but may be relatively stable in the lateral direction. A suitable configuration of the cushion layer 107, for achieving these attributes, is a foam structure, such that a compression along the proximodistal axis not will push material laterally. The void in the foam structure will compensate for the decrease in volume during compression. A suitable material for this purpose may be adhesive Cushion Mount™ (provided by 3M™), with a thickness in the interval of 300 to 800 micrometers, such as 400 to 600 micrometers. When the cushion layer 107 is arranged proximally of the insulating carrier sheet 103 and the routing layer 105, when using vacuum to hold the master electrode down against the master chuck, local deformation - entrapping electrolyte to impair ECPR - may be avoided by providing a uniform shape of the master electrode while sitting on the cushion layer 107. Vacuum may be applied proximally of the conductive foil 100, from a vacuum groove (connected to a vacuum supply unit) in the chuck, in positions corresponding to vacuum channels 108 through the insulating carrier sheet 103. The vacuum channels 108 run into vacuum grooves 109 on the distal side of the conductive foil 100, in between the rings contact layer 104. Conductive ridges 110 are thus connected to the routing layer 105 through conductive connections 106 in the carrier sheet 103. Ridges 111 not connected to the routing layer 105 are supporting ridges 111, assuring that proper support for the master electrode on top of the conductive foil 100 is obtained. Close to the periphery of the conductive foil 100 a seal gas channel 112 may be provided.

Fig. 2 discloses the proximal side of the contact foil 100, including a cushion layer at the most proximal position. Here, vacuum channels 201, corresponding to vacuum channels 108 in Fig. 1, are disclosed.

In Figs. 3 and 4 the distal/top side of the conductive foil 100 is disclosed. In Fig. 4, it is shown that thin, concentric parts of conductive ridges 401 are formed. Between conductive ridges 401, corresponding to conductive ridges 110 in Fig. 1, supporting ridges 402, corresponding to supporting ridge 111 in Fig. 1, are positioned. The length of the ridges may be increased by arranging the ridges in a meander-shaped distribution, as well as decreased by dividing it up into segments, within the sector. The distance between the ridges 401, 402 is kept between 0.05 and 2 millimeters, such as 0.5 millimeters. The ridges 401, 402 may have a width in the interval of 0.05 to 2 millimeters, such as 0.5 millimeters. In this way the mechanical support for the master electrode positioned on top of the conductive foil 100 is kept sufficiently high during appliance of vacuum through in the vacuum grooves 404, corresponding to vacuum grooves 109 in Fig. 1, which are distributed between the conductive ridges 402. Thus, the spacings between the ridges contributes to at least three technical effects in the increased voltage drop on the backside of the master electrode, leading to an increased amount of current running into the substrate; making possible different current strengths at different parts of the backside of the master electrode; and providing vacuum channels holding the master electrode in position on the conductive foil 100.

In Fig. 5 it is disclosed how the routing layer is separated into concentric and segmental zones 501, 502, 503, 504, 505, 506. These concentric and segmental zones 501, 502, 503, 504, 505, 506 are lead to terminals or contact ears 507, 508, 509, 510, one terminal or contact ear corresponding to one segment, by leads 511, 512, 513, 514, 515, 516, in four contact segments. When a multiple of terminals are arranged to feed separate segments, the current distribution may be improved, since the power drop in the circuits may be decreased. Also, different concentric segments may be provided with different currents to assure even plating on the substrate. The four identical segments, corresponding to terminals 507, 508, 509, 510 are provided to make sure that voltage/current is distributed uniformly over the entire circle. The current is distributed through the conductive foil 100 into the master electrode via the plating cells between the master electrode and the substrate, and then all the current run out through the substrate into the substrate contacts into a closed circuit. The number of concentric and segmental zones may vary, depending on the size of the substrate to be plated, and thus the master electrode to be used. Under normal conditions for performing ECPR plating of substrates the number of concentric and segmental zones vary in the interval of 2 to 50. Typically, to achieve a satisfactory current distribution, while not making the manufacturing process to complicated, the number of circuits would be between 2 and 10, such as 3 to 7. Also, the effective conductance may be kept sufficiently low for hindering the currents to travel to the edge of the master electrode. Here, it is also disclosed how through channels are positioned in a pattern of through holes in the shape of concentric circles 517, 518, 519, corresponding to the vacuum channel 108 and sealing gas channel 112, respectively. The concentric circle 517 is positioned close to the periphery of the conductive foil 100. This circle 517 is positioned in correspondence with a groove on the chuck, through which a sealing gas, such as nitrogen, helium, argon, or perhaps even air, may be provided. It is preferred that an inert gas is used, to minimize the risk of oxidation of the different parts of the master electrode or the conductive foil. The gas may then be supplied from the groove in the chuck through the conductive foil 100, to thereafter form a gas seal, such that electrolyte not has the possibility to enter the space between the master electrode and the conductive foil.

In one embodiment the gaps between the ridges 110, 111 have been partly filled with an insulating material, such as a dielectric material. When the gaps between the ridges 110, 111 have been partly filled with an insulating material, the rigidity on the macroscale could be increased, and a greater distance between the ridges 110, 111 could be allowed.

Fig. 6 is an exploded view, disclosing the electrical vias between conductive zones and conductive ridges according to one embodiment of the present invention. Here concentric and segmental patterns as well as a circular pattern of through holes 601, 602, 603, 604, 605, 606, filled with conductive material, such as metal, such as copper, conductive connections, corresponding to the conductive connections 106 in Fig. 1, are disclosed. Also large terminal or contact ear vias 607, 608, 609, 610 are disclosed. These large vias 607, 608, 609, 610 penetrate through the insulating carrier sheet 103, and allows for external contact.

It is readily understood that all references to lower/upper are merely for illustrative purposes, without any limiting effect on the scope of protection. Moreover, it should be realized that equivalent setups to those described may include setups having a substrate arranged on a lower chuck while the master electrode is mounted on an upper chuck, as well as setups in which the positions of the lower and upper chuck are switched.

In the claims, the term "comprises/comprising" does not exclude the presence of other elements or steps. Furthermore, although individually listed, a plurality of means, elements or method steps may be implemented by e.g. a single unit or processor. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. A contact sheet (100) for arrangement between a chuck and a master electrode for making electrical contact to the master electrode in an ECPR process, said contact sheet (100) having a first distal side (101) and a second proximal side (102), said contact sheet (100) comprising
an insulating carrier sheet (103);
distal electrically conductive contact portions (110) arranged distally of the insulating carrier sheet (103);
proximal electrically conductive contact portions (105) arranged proximally of the insulating carrier sheet (103);
said distal and proximal electrically conductive contact portions (105, 110) being connected by an electrically conductive material through the insulating carrier sheet (103).

2. The contact sheet (100) according to claim 1, wherein said distal electrically conductive contact portions (105) are at least parts of concentric rings.

3. The contact sheet (100) according to claim 2, wherein said at least parts of concentric rings are ridges (110), extending distally.

4. The contact sheet according to any of the preceding claims, wherein the proximal electrically conductive contact portions are comprised in a routing layer (105), formed as concentric segments, and said distal electrically conductive contact portions (110) arranged distally of the insulating carrier sheet (103) are formed as concentric and segmental rings into a contact layer (104), wherein concentric segments correspond to different concentric and segmental rings in the contact layer (104).

5. The contact sheet according to any of the preceding claims, wherein the concentric segments extend outwards/laterally by leads (511, 512, 513, 514, 515, 516) to terminals or contact ears (507, 508, 509, 510).

6. The contact sheet according to any of the preceding claims, wherein a cushion layer (107) is arranged on the proximal side of the insulating carrier sheet (103) and proximally of the proximal electrically conductive contact portions (105).

7. The contact sheet according to any of the preceding claims, wherein vacuum channels (108) extend proximodistally through the contact sheet (100).

8. The contact sheet according to claim 8, wherein the vacuum channels (108) run into vacuum grooves (109) for distributing vacuum on the distal side of the contact foil.

9. The contact sheet according to any of the preceding claims, comprising supporting ridges (111) on the distal side.

10. The contact sheet according to any of the preceding claims, comprising a seal gas channel (112) through the contact foil (100), close to the periphery of the contact sheet (100).

11. The contact sheet according to any of the preceding claims, wherein the insulating carrier (103) is of a suitable plastic material that is flexible on the global scale but not in the local scale of the context of ECPR.

12. The contact sheet according to any of the preceding claims, wherein the insulating carrier (103) is a liquid crystal polymer, such as LCP or PTFE or another fluorinated polymer material.

13. The contact sheet according to any of the preceding claims, wherein the insulating carrier (103) is in the form of a foam.

14. The contact sheet according to any of the preceding claims, wherein the insulating carrier (103) has a thickness in the interval of 30 to 70 micrometers.

15. The contact sheet according to claim 14, wherein the insulating carrier (103) has a thickness in the interval of 40 to 60 micrometers.

## Patentansprüche

1. Kontaktfolie (100) zur Anordnung zwischen einer Einspannvorrichtung und einer Masterelektrode zur Herstellung von elektrischem Kontakt zu der Masterelektrode in einem ECPR-Verfahren, wobei die Kontaktfolie (100) eine erste distale Seite (101) und eine zweite proximale Seite (102) aufweist, wobei die Kontaktfolie (100) umfasst
eine isolierende Trägerfolie (103);
distale elektrisch leitende Kontaktteile (110), die distal von der isolierenden Trägerfolie (103) angeordnet sind;
proximale elektrisch leitende Kontaktteile (105), die proximal von der isolierenden Trägerfolie (103) angeordnet sind;
wobei die distalen und proximalen elektrisch leitenden Kontaktteile (105, 110) mittels eines elektrisch leitenden Materials durch die isolierende Trägerfolie (103) hindurch verbunden sind.

2. Kontaktfolie (100) nach Anspruch 1, wobei die distalen elektrisch leitenden Kontaktteile (105) mindestens Teile konzentrischer Ringe sind.

3. Kontaktfolie (100) nach Anspruch 2, wobei die mindestens Teile konzentrischer Ringe Rippen (110) sind, die sich distal erstrecken.

4. Kontaktfolie nach einem der vorhergehenden Ansprüche, wobei die proximalen elektrisch leitenden Kontaktteile in einer Routinglage (105) enthalten sind, als konzentrische Segmente geformt, und die distalen elektrisch leitenden Kontaktteile (110), die distal von der isolierenden Trägerfolie (103) angeordnet sind, als konzentrische und segmentförmige Ringe in eine Kontaktlage (104) eingeformt sind, wobei konzentrische Segmente verschiedenen konzentrischen und segmentförmigen Ringen in der Kontaktlage (104) entsprechen.

5. Kontaktfolie nach einem der vorhergehenden Ansprüche, wobei die konzentrischen Segmente sich mittels Leitungen (511, 512, 513, 514, 515, 516) auswärts bzw. seitwärts zu Anschlussklemmen oder Kontaktlaschen (507, 508, 509, 510) erstrecken.

6. Kontaktfolie nach einem der vorhergehenden Ansprüche, wobei eine Polsterlage (107) an der proximalen Seite der isolierenden Trägerfolie (103) und proximal von den proximalen elektrisch leitenden Kontaktteilen (105) angeordnet ist.

7. Kontaktfolie nach einem der vorhergehenden Ansprüche, wobei Vakuumkanäle (108) sich proximodistal durch die Kontaktfolie (100) erstrecken.

8. Kontaktfolie nach Anspruch 7, wobei die Vakuumkanäle (108) in Vakuumrillen (109) zum Verteilen von Vakuum an der distalen Seite der Kontaktfolie führen.

9. Kontaktfolie nach einem der vorhergehenden Ansprüche, Stützrippen (111) an der distalen Seite umfassend.

10. Kontaktfolie nach einem der vorhergehenden Ansprüche, umfassend einen Dichtungsgaskanal (112) durch die Kontaktfolie (100), nahe am Außenumfang der Kontaktfolie (100).

11. Kontaktfolie nach einem der vorhergehenden Ansprüche, wobei der isolierende Träger (103) aus einem geeigneten Kunststoffmaterial besteht, das auf der globalen Skala flexibel ist, jedoch nicht auf der örtlichen Skala des Kontexts von ECPR.

12. Kontaktfolie nach einem der vorhergehenden Ansprüche, wobei der isolierende Träger (103) ein flüssigkristallines Polymer ist, wie etwa LCP oder PTFE oder ein anderes fluoriertes Polymermaterial.

13. Kontaktfolie nach einem der vorhergehenden Ansprüche, wobei der isolierende Träger (103) in Form eines Schaumstoffs vorliegt.

14. Kontaktfolie nach einem der vorhergehenden Ansprüche, wobei der isolierende Träger (103) eine Dicke im Bereich von 30 bis 70 Mikrometern aufweist.

15. Kontaktfolie nach Anspruch 14, wobei der isolierende Träger (103) eine Dicke im Bereich von 40 bis 60 Mikrometern aufweist.

## Revendications

1. Feuille de contact (100) pour son arrangement entre un mandrin et une électrode maître dans le but de conférer un contact électrique à l'électrode maître dans un procédé de réplication électrochimique de motifs (ECPR), ladite feuille de contact (100) possédant un premier côté distal (101) et un deuxième côté proximal (102), ladite feuille de contact (100) comprenant :
une feuille de support (103) procurant une isolation ;
des portions distales de contact électroconductrices (110) disposées en position distale par rapport à la feuille de support (103) procurant une isolation ;
des portions proximales de contact électroconductrices (105) disposées en position proximale par rapport à la feuille de support (103) procurant une isolation ;
lesdites portions distales et proximales de contact électroconductrices (105, 110) étant reliées par une matière électroconductrice à travers la feuille de support (103) procurant une isolation.

2. Feuille de contact (100) selon la revendication 1, dans laquelle lesdites portions distales de contact électroconductrices (105) représentent au moins des parties d'anneaux concentriques.

3. Feuille de contact (100) selon la revendication 2, dans laquelle lesdites au moins parties d'anneaux concentriques sont des nervures (110) s'étendant en direction distale.

4. Feuille de contact selon l'une quelconque de revendications précédentes, dans laquelle les portions proximales de contact électroconductrices sont comprises dans une couche d'acheminement (105) réalisée sous la forme de segments concentriques, et lesdites portions distales de contact électroconductrices (110) disposées en position distale par rapport à la feuille de support (103) procurant une isolation sont réalisées sous la forme d'anneaux concentriques et segmentaires dans une couche de contact (104), dans laquelle des segments concentriques correspondent à différents anneaux concentriques et segmentaires dans la couche de contact (104).

5. Feuille de contact selon l'une quelconque de revendications précédentes, dans laquelle les segments concentriques s'étendent vers l'extérieur/en direction latérale via des conducteurs (511, 512, 513, 514, 515, 516) jusqu'à des bornes ou des pattes de contact (507, 508, 509, 510).

6. Feuille de contact selon l'une quelconque de revendications précédentes, dans laquelle une couche d'amortissement (107) est disposée sur le côté proximal de la feuille de support (103) procurant une isolation et en direction proximale par rapport aux portions distales de contact électroconductrices (105).

7. Feuille de contact selon l'une quelconque de revendications précédentes, dans laquelle des canaux pour le vide (108) s'étendent en direction proximodistale à travers la feuille de contact (100).

8. Feuille de contact (100) selon la revendication 7, dans laquelle les canaux pour le vide (108) s'étendent jusque dans des rainures pour le vide (109) pour distribuer un vide sur le côté distal du film de contact.

9. Feuille de contact selon l'une quelconque de revendications précédentes, comprenant des nervures de support (111) sur le côté distal.

10. Feuille de contact selon l'une quelconque de revendications précédentes, comprenant un canal (112) pour un gaz d'étanchéité à travers le film de contact (100) à proximité de la périphérie de la feuille de contact (100).

11. Feuille de contact selon l'une quelconque de revendications précédentes, dans laquelle le support (103) procurant une isolation est constitué d'une matière plastique appropriée qui est flexible à l'échelle globale, mais non à l'échelle locale du contexte du procédé ECPR.

12. Feuille de contact selon l'une quelconque de revendications précédentes, dans laquelle le support (103) procurant une isolation est un polymère à cristaux liquides, tel que du LCP ou du PTFE ou une autre matière polymère fluorée.

13. Feuille de contact selon l'une quelconque de revendications précédentes, dans laquelle le support (103) procurant une isolation se présente sous la forme d'une mousse.

14. Feuille de contact selon l'une quelconque de revendications précédentes, dans laquelle le support (103) procurant une isolation possède une épaisseur dans la plage de 30 à 70 µm.

15. Feuille de contact selon l'une quelconque de revendications précédentes, dans laquelle le support (103) procurant une isolation possède une épaisseur dans la plage de 40 à 60 µm.
